# FASCICULE DE BREVET EUROPEEN

(11) **EP 3 939 396 B1**
(45) Date de publication et mention de la délivrance du brevet: **12.07.2023**
(21) Numéro de dépôt: 20707113.5
(22) Date de dépôt: 03.03.2020
(51) Int. Cl.: H05K 7/14

(54) **SYSTEME ELECTRONIQUE ET ENSEMBLE ELECTRIQUE**
ELEKTRONISCHES SYSTEM UND ELEKTRISCHE BAUGRUPPE
ELECTRONIC SYSTEM AND ELECTRICAL ASSEMBLY

(30) Priorité: 13.03.2019 FR 1902545
(43) Date de publication de la demande: 19.01.2022
(73) Titulaire: VALEO EQUIPEMENTS ELECTRIQUES MOTEUR, 94046 Créteil Cedex (FR)
(72) Inventeur: HOSNI, Alexis, 94046 Créteil Cedex (FR); VARILLON, Mathieu, 94046 Créteil Cedex (FR)
(74) Mandataire: Valeo Powertrain Systems
(86) Numéro de dépôt international: PCT/EP2020/055579
(87) Numéro de publication internationale: WO 2020/182547

(56) Documents cités:
- EP-A1- 2 736 160
- EP-A1- 2 741 412
- US-A1- 2009 237 905

## Description

L'invention porte sur un système électronique comprenant un moyen permettant de rapprocher deux barres omnibus connectées entre elles ainsi qu'un ensemble électrique comprenant un tel système électronique.

De manière connue, un système électronique comprend :
- un boitier,
- une première barre omnibus, par exemple une barre omnibus d'un module électronique de puissance destiné à alimenter un enroulement d'une phase d'une machine électrique tournante, fixée au boitier et comprenant une première extrémité de connexion présentant une première surface de connexion,
- unité électronique, par exemple un bloc de filtrage comprenant un condensateur, destiné à être inséré dans le boitier suivant une direction d'insertion comprenant :
   - un support,
   - une deuxième barre omnibus fixée au support et comprenant une deuxième extrémité de connexion présentant une deuxième surface de connexion,
dans lequel une connexion électrique entre la première surface de connexion et la deuxième surface de connexion est réalisée par soudage électrique.

Pour réaliser la soudure électrique il est nécessaire de plaquer la première surface de connexion sur la deuxième surface de connexion et de faire passer un courant électrique entre la première surface de connexion et la deuxième surface de connexion. Le placage de la première surface de connexion contre la deuxième surface de connexion nécessite l'utilisation d'un outil de presse encombrant limitant notamment la possibilité d'implantation de composants électroniques à proximité de la connexion électrique.

Pour résoudre ce problème d'encombrement important des outillages, il a également été envisagé de réaliser une soudure Laser entre la première surface de connexion et la deuxième surface de connexion. Cependant ce type de soudure nécessite un espacement précis entre la première surface de connexion et la deuxième surface de connexion. Un tel espacement précis est difficilement réalisable notamment en raison d'une chaine de cotes longue entre la première surface de connexion et la deuxième surface de connexion.

L'invention vise à supprimer tout ou partie de ces inconvénients.

L'invention porte sur un système électronique comprenant :
- un boitier comportant une première surface d'appui,
- une première barre omnibus fixée au boitier et comprenant une première extrémité de connexion présentant une première surface de connexion,
- une unité électronique comprenant une deuxième surface d'appui, l'unité électronique étant destinée à être insérée dans le boitier suivant une direction d'insertion et l'unité électronique comprenant :
   - un support,
   - une deuxième barre omnibus fixée au support et comprenant une deuxième extrémité de connexion présentant une deuxième surface de connexion,

la deuxième surface d'appui étant destinée à glisser sur la première surface d'appui lors de l'insertion de l'unité électronique dans le boitier,
dans lequel l'une de la première surface d'appui et de la deuxième surface d'appui comprend une rampe inclinée par rapport à la direction d'insertion pour déformer la deuxième barre omnibus de manière à rapprocher la deuxième surface de connexion de la première surface de connexion lors de l'insertion de l'unité électronique dans le boitier.

L'utilisation d'une telle rampe inclinée permet de réduire la tolérance sur la distance entre la première surface de connexion et la deuxième surface de connexion. Cette réduction de la tolérance permet notamment l'utilisation de soudure de type Laser entre la première extrémité de connexion de la première barre omnibus et la deuxième extrémité de connexion de la deuxième barre omnibus.

Ce type de soudure demande un outillage moins volumineux qu'une soudure électrique. De l'espace est donc libéré autour de la première extrémité de connexion de la première barre omnibus et la deuxième extrémité de connexion de la deuxième barre omnibus notamment pour l'implantation de composants électroniques.

Dans une première variante, la rampe est formée dans la deuxième barre omnibus.

La réalisation de la rampe dans la deuxième barre omnibus permet de réduire le nombre de pièces et l'assemblage du système électronique. Dans un tel cas la première surface d'appui peut porter un matériau isolant électriquement sur la première surface d'appui pour assurer l'isolation électrique entre le boitier et la deuxième barre omnibus.

Dans une deuxième variante, la rampe est formée dans la première surface d'appui et une cale est portée par la deuxième barre omnibus et interposée entre le boitier et la deuxième barre omnibus.

Dans une troisième variante, la rampe est formée dans la deuxième surface d'appui, la deuxième surface d'appui faisant partie d'une cale portée par la deuxième barre omnibus et interposée entre le boitier et la deuxième barre omnibus.

L'utilisation d'une cale dans la deuxième variante et la troisième variante permet de simplifier la mise en forme de la deuxième barre omnibus. En effet dans ces variantes il n'est pas nécessaire de réaliser de forme de rampe dans la deuxième barre omnibus. La forme de rampe est réalisée dans le boitier ou dans la cale, pièces dans lesquelles la fabrication d'une rampe est plus facile. Elle peut notamment être réalisée directement par moulage ou par usinage.

Selon une caractéristique supplémentaire de l'invention, la cale présente une troisième surface d'appui opposée à la deuxième surface d'appui et la deuxième barre omnibus présente une quatrième surface d'appui, la troisième surface d'appui étant en contact avec la quatrième surface d'appui.

Selon une caractéristique supplémentaire de l'invention, la cale est distincte du support et la cale est en appui sur le support lors de l'insertion du module électronique dans le boitier dans le sens opposé au sens d'insertion de l'unité électronique dans le boitier.

L'utilisation d'une cale distincte du support permet de simplifier la fabrication du support. En particulier dans le cas d'un support surmoulé sur la deuxième barre omnibus, l'outillage de moulage sera plus simple du fait de l'absence de tiroir pouvant être nécessaire à la réalisation de la cale.

Selon une caractéristique supplémentaire de l'invention, la cale est montée par verrouillage de forme sur la deuxième barre omnibus.

Le verrouillage de forme permet d'éviter une perte de la cale lors de la manutention de l'unité électronique.

Selon une caractéristique supplémentaire de l'invention, la deuxième barre omnibus comporte une portion plate avec deux bords et la cale présente deux glissières dans lesquelles se logent les deux bords de la portion plate de la deuxième barre omnibus.

Selon une caractéristique supplémentaire de l'invention, l'une de la cale et de la deuxième barre omnibus comprend un logement et l'autre de la cale et de la deuxième barre omnibus comprend une excroissance destinée à pénétrer dans le logement de manière à limiter le mouvement de la cale sur la deuxième barre omnibus dans le sens d'insertion de l'unité électronique dans le boitier.

Selon une caractéristique supplémentaire de l'invention, l'unité électronique est un bloc de filtrage comprenant un condensateur.

Selon une caractéristique supplémentaire, une borne du condensateur est directement connectée à la deuxième barre omnibus notamment par soudage, brasage ou sertissage. Selon une caractéristique supplémentaire de l'invention, la distance entre la première surface de connexion et la deuxième surface de connexion est comprise entre 0 et 0,7mm, de préférence entre 0 et 0,5mm.

Une telle distance permet de réaliser une soudure laser sans outillage permettant de rapprocher la première surface de connexion de la deuxième surface de connexion.

Selon une caractéristique supplémentaire de l'invention, la première extrémité de connexion de la première barre omnibus est soudée, notamment par soudure Laser, à la deuxième extrémité de connexion de la deuxième barre omnibus.

Selon une caractéristique supplémentaire de l'invention, l'unité électronique comprend un couvercle comprenant une partie métallique au droit de l'un interstice formé entre la première surface de connexion de la première barre omnibus et la deuxième surface de connexion de la deuxième barre omnibus dans la direction d'insertion.

EP 2736160 A1, EP 2741412 A1, US 2009/237905 A1 se rapportent aux systèmes électroniques surtout avec des convertisseurs de puissance.

L'utilisation d'une telle partie métallique permet de bloquer le faisceau Laser après la zone à souder.

L'invention porte également sur un ensemble électrique comprenant :
- un système électronique tel que décrit précédemment,
- une machine électrique tournante.

L'invention pourra être mieux comprise à la lecture de la description qui va suivre d'exemples non limitatifs de mise en oeuvre de celle-ci et à l'examen du dessin annexé sur lequel :
- [Fig. 1] la figure 1 représente un schéma électrique d'un ensemble électrique comportant un système électronique selon l'invention,
- [Fig. 2] la figure 2 représente une vue de dessus d'un système électronique,
- [Fig. 3] la figure 3 représente une vue en coupe partielle d'un système électronique en l'absence de l'invention,
- [Fig. 4] la figure 4 représente une vue schématique en coupe partielle d'un système électronique selon un premier mode de réalisation de l'invention,
- [Fig. 5] la figure 5 représente une vue en coupe partielle du système électronique de la figure 4 dans une première étape de montage,
- [Fig. 6] la figure 6 représente une vue en coupe partielle du système électronique de la figure 4 dans une deuxième étape de montage,
- [Fig. 7] la figure 7 représente une vue en coupe partielle du système électronique de la figure 4 dans une troisième étape de montage,
- [Fig. 8] la figure 8 représente une vue en coupe partielle du système électronique de la figure 4,
- [Fig. 9] la figure 9 représente une vue partielle d'une unité électronique d'un système électronique de la figure 4 selon un deuxième mode de réalisation,
- [Fig. 10] la figure 10 représente une vue partielle de l'unité électronique de la figure 9.

Sur toutes les figures, les éléments identiques ou assurant la même fonction portent les mêmes numéros de référence. Les réalisations suivantes sont des exemples. Bien que la description se réfère à un ou plusieurs modes de réalisation, ceci ne signifie pas nécessairement que chaque référence concerne le même mode de réalisation ou que les caractéristiques s'appliquent seulement à un seul mode de réalisation. De simples caractéristiques de différents modes de réalisation peuvent également être combinées ou interchangées pour fournir d'autres réalisations.

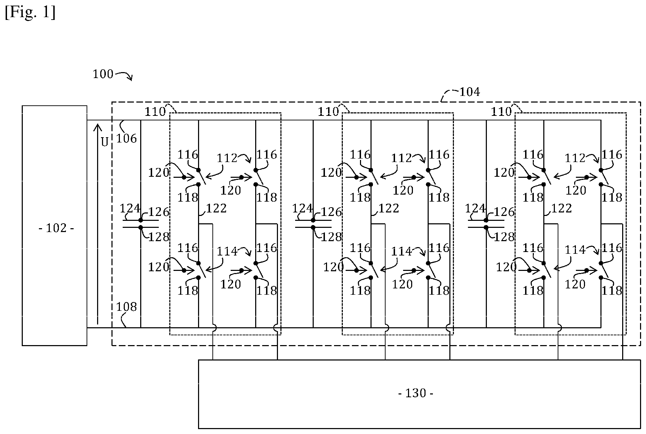

La figure 1 représente un ensemble électrique 100 dans lequel peut être mis en oeuvre l'invention.

L'ensemble électrique 100 est par exemple destiné à être implanté dans un véhicule automobile.

L'ensemble électrique 100 comporte tout d'abord une source d'alimentation électrique 102 conçue pour fournir une tension continue U, par exemple comprise entre 20 V et 100 V, par exemple 48 V. La source d'alimentation électrique 102 comporte par exemple une batterie.

L'ensemble électrique 100 comporte en outre une machine électrique tournante 130 comportant plusieurs enroulements de phase (non représentés) destinées à présenter des tensions de phase respectives.

L'ensemble électrique 100 comporte en outre un système électronique 104.

Dans les différents modes de réalisation représentés sur les figures le système électronique 104 est un convertisseur de tension 104. Cependant dans d'autres modes de réalisation non représentés l'ensemble peut assurer une fonction différente.

Le convertisseur de tension 104 est connecté entre la source d'alimentation électrique 102 et la machine électrique 130 pour effectuer une conversion entre la tension continue U et les tensions de phase.

Le convertisseur de tension 104 comporte tout d'abord une ligne électrique positive 106 et une ligne électrique négative 108 destinées à être connectées à la source d'alimentation électrique 102 pour recevoir la tension continue U, la ligne électrique positive 106 recevant un potentiel électrique haut et la ligne électrique négative 108 recevant un potentiel électrique bas.

Le convertisseur de tension 104 comporte en outre au moins un module électronique de puissance 110 comportant une ou plusieurs lignes électriques de phase 122 destinées être respectivement connectées à une ou plusieurs phases de la machine électrique 130, pour fournir leurs tensions de phase respectives.

Dans l'exemple décrit, le convertisseur de tension 104 comporte trois modules électroniques de puissance 110 comportant chacun deux lignes électriques de phase 122 connectées à deux phases de la machine électrique 130.

Plus précisément, dans l'exemple décrit, la machine électrique 130 comporte deux systèmes triphasés comportant chacun trois phases, et destinés à être électriquement déphasés de 120° l'un par rapport à l'autre. De préférence, les premières lignes électriques de phase 122 des modules électroniques de puissance 110 sont respectivement connectées aux trois phases du premier système triphasé, tandis que les deuxièmes lignes électriques de phase 122 des modules électroniques de puissance 110 sont respectivement connectées aux trois phases du deuxième système triphasé.

Chaque module électronique de puissance 110 comporte, pour chaque ligne électrique de phase 122, un premier interrupteur commandable 112 connecté entre la ligne électrique positive 106 et la ligne électrique de phase 122 et un deuxième interrupteur commandable 114 connecté entre la ligne électrique de phase 122 et la ligne électrique négative 108. Ainsi, les interrupteurs commandables 112, 114 sont agencés de manière à former un bras de hachage, dans lequel la ligne électrique de phase 122 forme un point milieu.

Chaque interrupteur commandable 112, 114 comporte des première et deuxième bornes principales 116, 118 et une borne de commande 120 destinée à sélectivement ouvrir et fermer l'interrupteur commandable 112, 114 entre ses deux bornes principales 116, 118 en fonction d'un signal de commande qui lui est appliqué. Les interrupteurs commandables 112, 114 sont de préférence des transistors, par exemple des transistors à effet de champ à structure métal-oxyde-semiconducteur (de l'anglais « Metal Oxide Semiconductor Field Effect Transistor » ou MOSFET) présentant une grille formant la borne de commande 120, et un drain et une source formant respectivement les bornes principales 116, 118.

Dans l'exemple décrit, les interrupteurs commandables 112, 114 ont chacun la forme d'une plaque, par exemple sensiblement rectangulaire, présentant une face supérieure et une face inférieure. La première borne principale 116 s'étend sur la face inférieure, tandis que la deuxième borne principale 118 s'étend sur la face supérieure. En outre, la face inférieure forme une face de dissipation de chaleur.

Le convertisseur de tension 104 comporte en outre, pour chaque module électronique de puissance 110, une capacité de filtrage 124 présentant une première borne 126 et une deuxième borne 128 respectivement connectées à la ligne électrique positive 106 et à la ligne électrique négative 108.

Il sera apprécié que la ligne électrique positive 106, la ligne électrique négative 108 et les lignes électriques de phase 122 sont des éléments rigides conçus pour supporter des courants électriques d'au moins 1 A. Elles présentent de préférence une épaisseur d'au moins 1 mm.

En outre, dans l'exemple décrit, la machine électrique 130 a à la fois une fonction d'alternateur et de moteur électrique. Plus précisément, le véhicule automobile comporte en outre un moteur thermique (non représenté) présentant un axe de sortie auquel la machine électrique 130 est reliée par une courroie (non représentée). Le moteur thermique est destiné à entraîner des roues du véhicule automobile par l'intermédiaire de son axe de sortie. Ainsi, en fonctionnement comme alternateur, la machine électrique fournit de l'énergie électrique en direction de la source d'alimentation électrique 102 à partir de la rotation de l'axe de sortie. Le convertisseur de tension 104 fonctionne alors comme redresseur. En fonctionnement comme moteur électrique, la machine électrique entraîne l'arbre de sortie (en complément ou bien à la place du moteur thermique). Le convertisseur de tension 104 fonctionne alors comme onduleur.

La machine électrique 130 est par exemple localisée dans une boîte de vitesses ou bien dans un embrayage du véhicule automobile ou bien en lieu et place de l'alternateur.

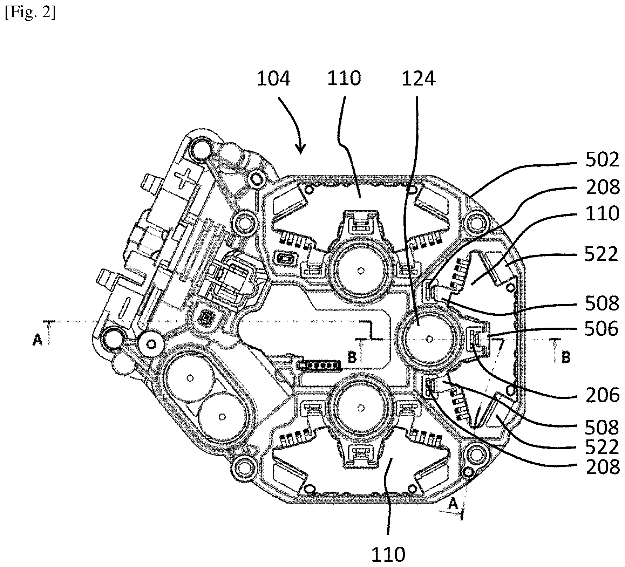

La figure 2 représente un convertisseur de tension 104 comprenant :
- un boitier 502,
- un module électronique de puissance 110,
- une capacité de filtrage 124.

Le module électronique de puissance 110 comprend une première barre omnibus 506, 508. La première barre omnibus 506, 508 est par exemple une première barre omnibus 506 positive connectée électriquement à la ligne électrique positive 106 ou une première barre omnibus 508 négative connectée à la ligne électrique négative 108.

Le module électronique de puissance 110 comprend en outre une barre omnibus 522 connectée à une des lignes électriques de phase 122.

La première barre omnibus 506, 508 est connectée à une deuxième barre omnibus 206, 208. La deuxième barre omnibus 206, 208 est par exemple une deuxième barre omnibus 206 positive connectée électriquement à la ligne électrique positive 106 ou une deuxième barre omnibus 208 connectée à la ligne électrique négative 108.

La deuxième barre omnibus 206, 208 est par exemple connectée électriquement à la première borne 126 ou à la deuxième borne 128 de la capacité de filtrage 124.

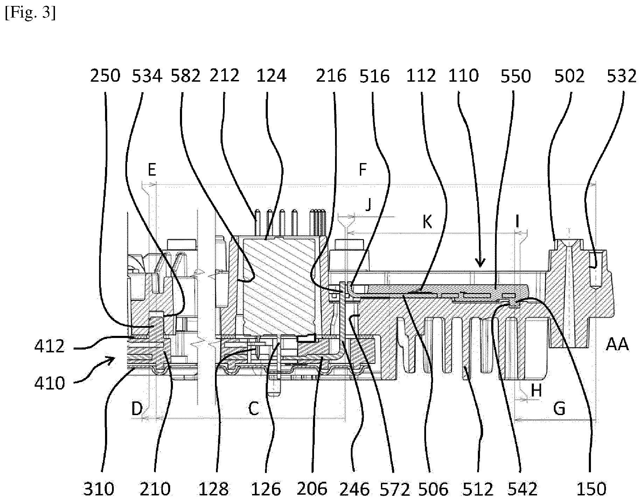

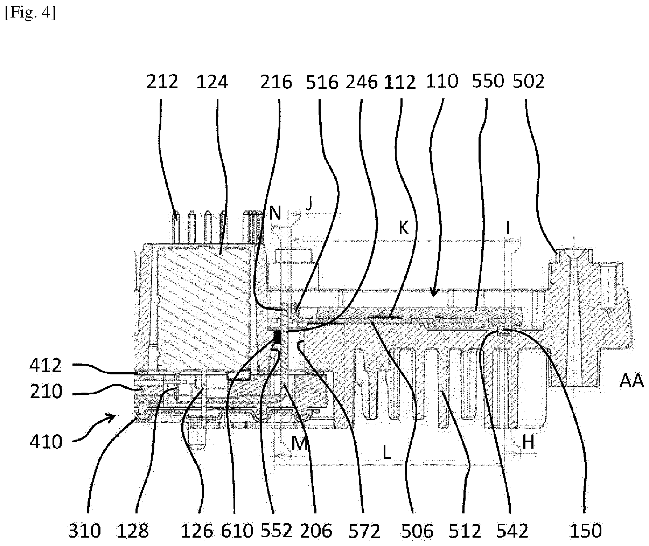

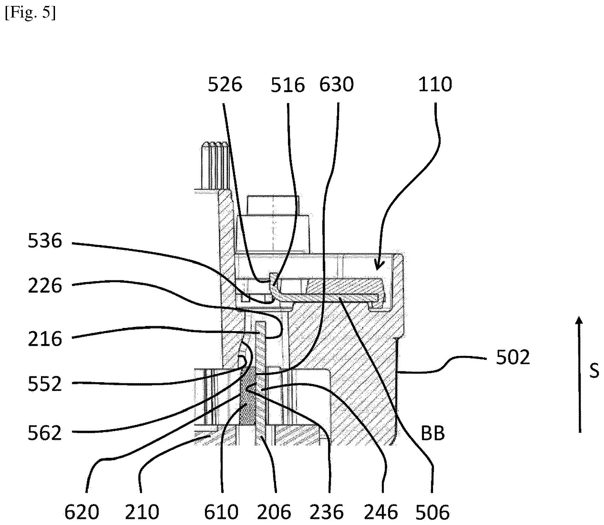

Sur la figure 2 sont représentés en outre un premier tracé AA de la coupe brisée représentée sur la figure 3 et la figure 4 et un deuxième tracé BB de la coupe brisée représentée sur la figure 5, la figure 6, la figure 7 et la figure 8.

La figure 3 représente une coupe du convertisseur de tension 104 pour illustrer le problème technique à résoudre par l'invention.

Le module électronique de puissance 110 peut comprendre en outre une broche de commande 212 connectée à la borne de commande 120.

Le module électronique de puissance peut comprendre en outre une boite surmoulée 550 sur le premier interrupteur commandable 112, le deuxième interrupteur commandable 114, la première barre omnibus 506 et la broche de commande 212.

Le module électronique de puissance 110 est fixé sur le boitier 502 à l'aide d'un moyen de fixation non représenté.

Le module électronique de puissance 110 comprend une face inférieure et une face supérieure. La face inférieure du module de puissance 110 comprend une surface de dissipation thermique. Cette surface de dissipation thermique est en contact thermique avec une surface d'échange thermique du boitier 502. Le contact thermique est par exemple réalisé grâce à une pâte thermique ou une colle thermique.

Le boitier 502 peut également comprendre des ailettes de refroidissement 512 par exemple sur la surface de la boitier 502 opposée à la surface d'échange thermique du boitier 502.

Le module électronique de puissance 110 est positionné sur le boitier 502 grâce à des premiers moyens de positionnement. Les premiers moyens de positionnement comprennent par exemple un premier pion de positionnement 150 et un premier trou de positionnement 542. Le premier pion de positionnement 150 est par exemple formé dans la boîte surmoulée 550. Le premier trou de positionnement 542 est par exemple formé dans le boitier 502. Les premiers moyens de positionnement peuvent comprendre une pluralité de premiers pions de positionnement 150 et de premiers trous de positionnement 542.

Le convertisseur de tension 104 comprend en outre une unité électronique 410 destinée à être insérée dans le boitier 502 suivant une direction d'insertion S.

L'unité électronique 410 comprend :
- un support 210,
- la deuxième barre omnibus 206, 208, la deuxième barre omnibus 206, 208 étant fixée au support 210.

L'unité électronique 410 peut comprendre en outre la capacité de filtrage 124.

La première borne 126 de la capacité de filtrage 124 est par exemple connectée la deuxième barre omnibus positive 206 et la deuxième borne de la capacité de filtrage 124 est par exemple connectée à deuxième barre omnibus négative 208.

Le support 210 est par exemple surmoulé sur la deuxième barre omnibus 206, 208.

Le support 210 comprend une première zone d'appui venant en appui sur une deuxième zone d'appui du boitier 502 à la fin de l'insertion de l'unité électronique 410 dans le boitier 502.

L'appui entre la première zone d'appui et la deuxième zone d'appui peut être réalisé par l'intermédiaire d'un joint 412, par exemple un joint de colle.

L'unité électronique 410 est positionné par rapport au boitier 502 grâce à des deuxièmes moyens de positionnement. Les deuxièmes moyens de positionnement comprennent par exemple un deuxième pion de positionnement 250 et un deuxième trou de positionnement 534. Le deuxième pion de positionnement 250 est par exemple formé dans le support 210. Le deuxième trou de positionnement 534 est par exemple formé dans le boitier 502. Les deuxièmes moyens de positionnement peuvent comprendre une pluralité de deuxièmes pions de positionnement 250 et de deuxièmes trous de positionnement 534.

L'unité électronique 410 peut comprendre en outre un couvercle 310. Le couvercle 310 est fixé sur le support 210 par exemple par collage. Un joint non représenté peut assurer une étanchéité entre le support 210 et le couvercle 310. La colle peut assurer la fonction de joint.

Cette étanchéité entre le couvercle 310 et la support 210 forme un réservoir dans lequel il est possible de couler un gel ou une résine pour protéger, par exemple contre la corrosion, les parties qui ne sont pas surmoulées par le support 210 de la deuxième barre omnibus 206 et les bornes 126, 128 du condensateur.

L'utilisation du joint 412 entre le support 210 et le boitier 502 permet d'augmenter le volume du réservoir et donc d'augmenter les surfaces protégées par le gel ou la résine.

Le boitier 502 peut comprendre un trou de centrage 532 servant de référence pour le positionnement des moyens de positionnement des éléments montés sur le boitier 502, comme le module électronique de puissance 110 et l'unité électronique 410.

La première barre omnibus 506, 508 comprend une première partie globalement orientée dans la direction d'insertion S. La première partie comprend une première extrémité de connexion 516 présentant une première surface de connexion 526.

La première extrémité de connexion 516 peut-être notamment perpendiculaire à la partie de la première barre omnibus 506, 508 qui est dans la boite 550.

La première extrémité de connexion 516 peut former un coude 536 avec la partie de la première barre omnibus 506, 508 qui est dans la boite 550.

La deuxième barre omnibus 206, 208 comprend une deuxième partie 246 globalement orientée dans la direction d'insertion S. La deuxième partie 246 comprend une deuxième extrémité de connexion 216 présentant une deuxième surface de connexion 226.

Le boitier 502 comprend une ouverture 572 permettant le passage de la deuxième partie 246 lors de l'insertion de l'unité électronique 410 dans le boitier 502.

Le boitier 502 peut également comprendre une cavité 582 pour loger la capacité 124. Dans les différents exemples représentés sur les figures la cavité 582 est traversante.

Dans d'autres exemples non représentés sur les figures, la cavité 582 peut être non débouchante. Ce type de cavités non débouchantes présente un fond. Le fond peut comprendre une surface d'échange thermique avec la capacité 124 de manière à faciliter l'évacuation des calories générées par la capacité 124 par le boitier 502.

Une fois l'unité électronique 410 insérée dans la boitier 502, la première extrémité de connexion 516 et la deuxième extrémité de connexion 216 sont au même niveau dans la direction d'insertion S de manière à ce que la première surface de connexion 526 fait face à la deuxième surface de connexion 226.

Pour réaliser une connexion électrique entre la première surface de connexion 526 et la deuxième surface de connexion 226 il est utile de bien maîtriser la distance J entre la première surface de connexion 526 et la deuxième surface de connexion 226.

Par exemple l'utilisation d'un procédé de soudure Laser pour réaliser la connexion électrique entre la première surface de connexion 526 et la deuxième surface de connexion 226 nécessite une distance J entre la première surface de connexion 526 et la deuxième surface de connexion 226 comprise entre 0 et 0,7mm, de préférence entre 0 et 0,5mm.

D'autres procédés de soudage tel que la soudure TIG ou soudure sous gaz inerte avec électrode en tungstène (Tungsten Inert Gas en anglais) peuvent être également utilisés. Une tolérance similaire sur la distance J entre la première surface de connexion 526 et la deuxième surface de connexion 226 doit également être respectée pour obtenir une bonne connexion électrique.

La distance J entre la première surface de connexion 526 et la deuxième surface de connexion 226 dépend d'une chaine de cote longue qui rend difficile le respect d'une tolérance dimensionnelle adaptée à la réalisation d'une connexion par soudure entre la première surface de connexion 526 et la deuxième surface de connexion 226.

En effet la chaine de cote comprend, dans le convertisseur de tension 104 représenté sur la figure 3, les dimensions mesurées dans un plan perpendiculaire à la direction d'insertion suivantes :
- la distance C entre la deuxième surface de connexion 226 et le deuxième pion de positionnement 250,
- le rayon D du deuxième pion de positionnement 250,
- le rayon E du deuxième trou de positionnement 534,
- la distance F entre le deuxième trou de positionnement 534 et le trou de centrage 532,
- la distance G entre le trou de centrage 532 et le premier trou de positionnement 542,
- le rayon H du premier trou de positionnement 542,
- le rayon I du premier pion de positionnement 150, et
- la distance K entre le premier pion de positionnement 150 et la première surface de connexion 526.

La figure 4 représente de manière schématique un convertisseur de tension 104 selon l'invention.

Le convertisseur de tension de la figure 4 est similaire au convertisseur de tension de la figure 3. Cependant l'unité électronique 410 comprend en outre une cale 610 interposée entre une première surface d'appui 552 du boitier 502 et la deuxième partie 246 de la deuxième barre omnibus 206, 208.

La cale (610) est réalisée dans un matériau isolant électrique notamment une matière plastique.

La première surface d'appui 552 est formée dans l'ouverture 572 du boitier 502.

L'utilisation de la cale 610 entre la première surface d'appui 552 et la deuxième barre omnibus 206 permet de réduire la tolérance sur la distance J entre la première surface de connexion 526 et la deuxième surface de connexion 226 en réduisant la longueur de la chaine de cote entre la première surface de connexion 526 et la deuxième surface de connexion 226.

La chaine de cote comprend, dans le convertisseur de tension 104 représenté sur la figure 4, les dimensions mesurées dans un plan perpendiculaire à la direction d'insertion suivantes :
- l'épaisseur N de la deuxième partie 246 de la barre deuxième barre omnibus 206,
- l'épaisseur M de la cale 610,
- la distance L entre la première surface d'appui 552 et le premier trou de positionnement 542,
- le rayon H du premier trou de positionnement 542,
- le rayon I du premier pion de centrage 150, et
- la distance K entre le premier pion de centrage 150 et la première surface de connexion 526.

Cette réduction de la chaine de cote liée à la distance J entre la première surface de connexion 526 et la deuxième surface de connexion 226 permet d'améliorer et donc réduire la tolérance sur la distance J entre la première surface de connexion 526 et la deuxième surface de connexion 226.

La figure 5, la figure 6, la figure 7 et la figure 8 représentent différentes étapes de l'insertion de l'unité électronique 410 dans le boitier 502 du convertisseur de tension 104 selon un premier mode de réalisation.

La première surface d'appui 552 comprend une rampe 562 inclinée par rapport à la direction d'insertion S.

La cale 610 est en appui sur le support 210 dans le sens opposé au sens d'insertion de l'unité électronique 410 dans le boitier 502.

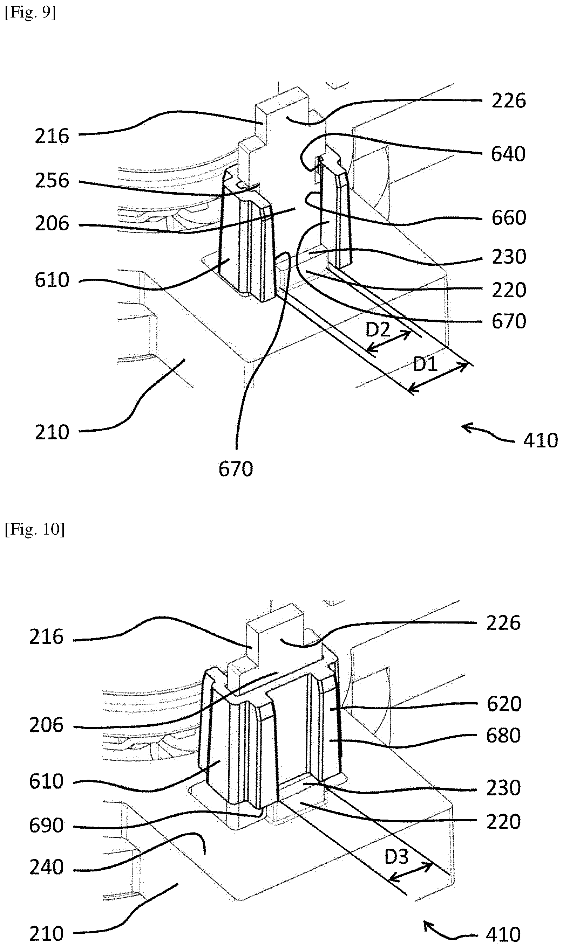

La cale 610 est par exemple portée par la deuxième barre omnibus 206, 208. Une description plus détaillée d'un exemple de liaison entre la cale et la deuxième barre omnibus 206, 208 sera donnée pour le mode de réalisation représenté sur la figure 9 et la figure 10.

La cale 610 comprend une deuxième surface d'appui 620 destinée à glisser sur la première surface d'appui 552 lors de l'insertion de l'unité électronique 410 dans le boitier 502.

La cale 610 comprend en outre une troisième surface d'appui 630. La troisième surface d'appui 630 est en appui sur une quatrième surface d'appui formée sur la deuxième partie 246 de la deuxième barre omnibus 206, 208.

La figure 5 représente une première étape de l'insertion de l'unité électronique 410 dans le boitier 502 du convertisseur de tension 104 selon le premier mode de réalisation.

Au cours de cette première étape, la deuxième surface d'appui 620 de la cale 610 peut entrer en contact et commencer à glisser sur la première surface d'appui 552. Cependant un tel glissement n'est pas nécessaire. Le déplacement relatif entre la deuxième surface d'appui 620 de la cale 610 et la première surface d'appui 552 peut donc être réalisé à distance c'est-à-dire sans contact

La deuxième barre omnibus 206, 208 est peu déformée notamment n'est pas déformée s'il n'y a pas de contact.

A la fin de cette première étape la deuxième surface de connexion 226 peut commencer à faire face à la première surface de connexion 526. En d'autres termes la deuxième surface de connexion 226 peut commencer à chevaucher la première surface de connexion 526 dans la direction d'insertion S. Il est ainsi possible d'éviter un contact entre la deuxième surface de connexion 226 et le coude 536. Un tel contact pourrait rendre plus difficile voire impossible l'insertion de l'unité électronique 410 dans le boitier 502.

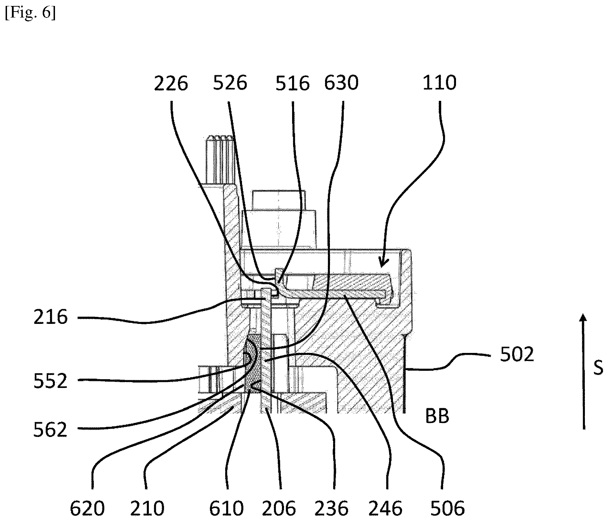

La figure 6 représente une deuxième étape de l'insertion de l'unité électronique 410 dans le boitier 502 du convertisseur de tension 104 selon le premier mode de réalisation.

Au cours de cette deuxième étape, la deuxième surface d'appui 620 de la cale 610 glisse sur la rampe 562 de la première surface d'appui 552. La troisième surface d'appui 630 de la cale 610 étant en contact avec la quatrième surface d'appui 236 de la deuxième barre omnibus 206, 208, un effort sensiblement perpendiculaire à la direction d'insertion S est généré sur la deuxième partie 246 de la deuxième barre omnibus 206, 208. Cet effort déforme la deuxième barre omnibus 206, 208 de manière à rapprocher la deuxième surface de connexion 226 de la première surface de connexion 526.

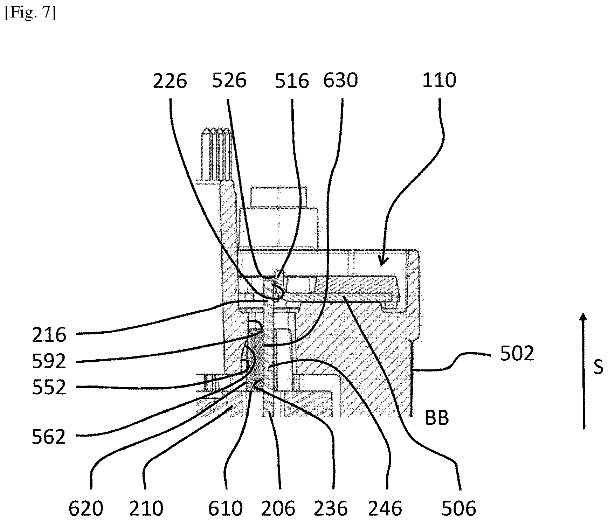

La figure 7 représente une troisième étape de l'insertion de l'unité électronique 410 dans le boitier 502 du convertisseur de tension 104 selon le premier mode de réalisation.

La première surface d'appui 552 comprend en outre une surface de référence 592.

Au cours de cette troisième étape, la deuxième surface d'appui 620 de la cale 610 glisse sur la surface de référence 592. La distance J entre la deuxième surface de connexion 226 de la première surface de connexion 526 reste constante.

La chaine de cote plus courte vue précédemment permet de réduire les tolérances dimensionnelles sur la distance J entre la deuxième surface de connexion 226 de la première surface de connexion 526. Il est ainsi possible d'obtenir une distance J entre la première surface de connexion 526 et la deuxième surface de connexion 226 comprise entre 0 et 0,7mm, de préférence entre 0 et 0,5mm.

Un interstice est formé entre la première surface de connexion 526 de la première barre omnibus 506, 508 et la deuxième surface de connexion 226 de la deuxième barre omnibus 206, 208.

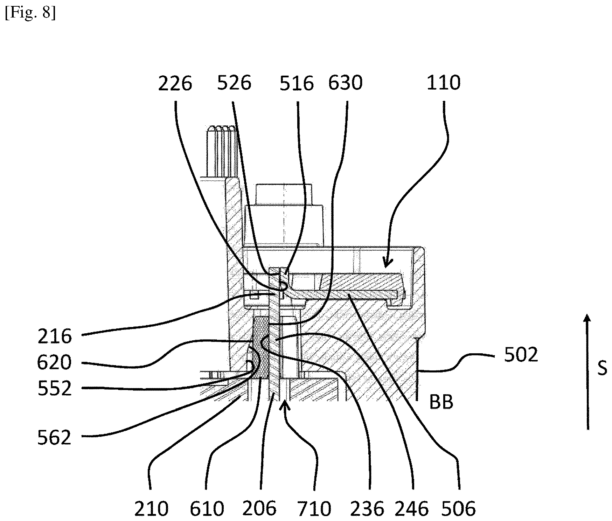

Sur la figure 8 l'unité électronique 410 est dans sa position finale après insertion dans le boitier 502.

La tolérance dimensionnelle réduite sur la distance J entre la deuxième surface de connexion 226 de la première surface de connexion 526 permet par exemple l'utilisation d'une soudure de type Laser pour connecter électriquement la première surface de connexion 526 et la deuxième surface de connexion 226.

Dans le cas de l'utilisation d'une soudure Laser entre la deuxième surface de connexion 226 de la première surface de connexion 526, il est particulièrement utile de ménager un espace ouvert 710 dans la cale 610 et le support 210 au droit de la zone de soudure entre la deuxième surface de connexion 226 et la première surface de connexion.

Il est avantageux de bloquer le faisceau Laser avec une partie métallique. Le couvercle 310 peut comprendre cette partie métallique.

D'autre type de soudure comme la soudure TIG peuvent être rendus réalisables grâce à cette réduction de la tolérance dimensionnelle sur la distance J entre la deuxième surface de connexion 226 de la première surface de connexion 526.

La figure 9 et la figure 10 représentent un deuxième mode de réalisation de l'invention dans lequel l'unité électronique a été améliorée par l'ajout d'un dispositif de détrompage de manière éviter un mauvais montage de la cale 610.

Dans le deuxième mode de réalisation, la deuxième partie 246 de deuxième barre omnibus 206, 208 comporte une portion plate avec deux bords. La portion plate présente une première surface plane et une deuxième surface plane opposée à la première surface plane. La première surface plane et la deuxième surface plane sont reliées par les deux bords.

La quatrième face d'appui 236 de la deuxième barre omnibus 206, 208 est formée sur la première surface plane.

La cale 610 présente deux glissières 660 dans lesquelles se logent les deux bords de la portion plate de la deuxième partie 246 de la deuxième barre omnibus 206, 208.

Au moins une glissière 660 comprend une excroissance 640.

Le bord de la portion plane logé dans la glissière 660 comprenant l'excroissance 640 présente un logement 256 dans lequel vient se loger l'excroissance 660 lors de l'insertion de la portion des bords de la portion plate de la deuxième barre omnibus 206, 208 dans les glissières 660. L'excroissance 660 et le logement 256 permettent d'assurer un verrouillage de forme du montage de la cale 610 sur l'unité électronique 410.

Le mouvement de la cale 610 sur la deuxième partie 246 de la deuxième barre omnibus 206, 208 dans le sens d'insertion S de l'unité électronique 410 dans le boitier 502 est ainsi limité.

La cale 610 est par exemple en appui sur le support 210.

Le dispositif de détrompage comprend par exemple :
- deux parois 670 orientées perpendiculairement à la deuxième portion plate et dans la direction l'insertion S, les deux parois étant distantes d'une première distance D1,
- un plot 220 formé sur le support 210, le plot 220 ayant une longueur D2 inférieure à D1 de manière à pouvoir être inséré entre les deux parois 670.

Le plot 220 comprend une première surface de butée 230 décalé par rapport à une surface de contact 240 du support 210 sur laquelle la cale 610 est en appui.

La cale 610 comprend deux nervures 680 séparées d'une troisième distance D3. Les nervures portent la deuxième surface d'appui 620.

Les nervures comprennent une deuxième surface de butée 690 qui fait face au support 210.

La troisième distance D3 est inférieure à la deuxième distance D2.

La figure 10 représente une tentative d'insertion de la cale 610 sur la deuxième partie 246 de la deuxième barre omnibus 206, 208 dans une mauvaise orientation.

La cale 610 est bloquée par le plot 220. La deuxième surface de butée 690 vient en butée contre la première surface de butée 230. Ainsi la cale 610 ne peut pas venir en appui sur la surface de contact 240. La mauvaise orientation de la cale 210 peut alors être détectée facilement par exemple visuellement ou avec des moyens de détection automatisés optiques.

Dans d'autres mode de réalisation d'autres dispositifs de détrompage sont utilisés.

Dans un mode de réalisation non représenté le dispositif de détrompage comprend une excroissance dans la cale ne pouvant être insérée dans un logement formé dans le support que lorsque la cale est correctement orientée.

Dans un autre mode de réalisation non représenté le dispositif de détrompage comprend deux excroissances décalées dans la direction S dans les glissières et des logements également décalés dans les bords de la portion plane.

Dans un autre mode de réalisation non représenté la cale est formée avec le support. Par exemple le support et la cale sont réalisés par surmoulage d'une matière isolante électriquement sur la deuxième barre omnibus.

Dans une première variante de ce mode de réalisation, la cale et le support sont séparée.

Dans une deuxième variante de ce mode de réalisation, la cale et le support sont formés en continuité de matière. Avantageusement une partie amincie peut être formée entre le support et la cale de manière à faciliter la déformation de la deuxième barre omnibus lors de l'insertion de l'unité électronique dans le boitier.

Dans un autre mode de réalisation non représenté la rampe est formée sur la cale.

Dans un autre mode de réalisation non représenté une rampe est formée sur la cale et une rampe est formée sur la première surface d'appui.

Dans un autre mode de réalisation non représenté, la rampe est formée dans la deuxième barre omnibus.

Dans ce mode de réalisation la première surface d'appui du boitier est réalisée dans un matériau isolant électriquement notamment une matière plastique. Par exemple le boitier est réalisé en matière plastique surmoulé sur des inserts métalliques de dissipation thermique comprenant la surface d'échange thermique du boitier, cette surface d'échange thermique étant en contact thermique de la surface de dissipation thermique du module électronique de puissance.

## Revendications

1. Système électronique (104) comprenant :
a. un boitier (502) comportant une première surface d'appui (552),
b. une première barre omnibus (506, 508) fixée au boitier et comprenant une première extrémité de connexion (516) présentant une première surface de connexion (526),
c. une unité électronique (410) comprenant une deuxième surface d'appui (620), l'unité électronique (410) étant destinée à être insérée dans le boitier (502) suivant une direction d'insertion (S) et l'unité électronique (410) comprenant :
i. un support (210),
ii. une deuxième barre omnibus (206, 208) fixée au support (210) et comprenant une deuxième extrémité de connexion (216) présentant une deuxième surface de connexion (226),
la deuxième surface d'appui (620) étant destinée à glisser sur la première surface d'appui (552) lors de l'insertion de l'unité électronique (410) dans le boitier (502), dans lequel l'une de la première surface d'appui (552) et de la deuxième surface d'appui (620) comprend une rampe (562) inclinée par rapport à la direction d'insertion (S) pour déformer la deuxième barre omnibus (206, 208) de manière à rapprocher la deuxième surface de connexion (226) de la première surface de connexion (526) lors de l'insertion de l'unité électronique (410) dans le boitier (502).

2. Système électronique (104) selon la revendication 1 dans lequel la rampe est formée dans la deuxième barre omnibus (206, 208).

3. Système électronique (104) selon la revendication 1 dans lequel la rampe (562) est formée dans la première surface d'appui (552).

4. Système électronique (104) selon la revendication 3 dans lequel une cale (610) est portée par la deuxième barre omnibus (206, 208) et interposée entre le boitier (502) et la deuxième barre omnibus (206, 208).

5. Système électronique (104) selon la revendication 1 dans lequel la rampe est formée dans la deuxième surface d'appui (620), la deuxième surface d'appui faisant partie d'une cale (610) portée par la deuxième barre omnibus (206, 208) et interposée entre le boitier (502) et la deuxième barre omnibus (206, 208).

6. Système électronique (104) selon l'une des revendications 4 et 5 dans lequel la cale (610) présente une troisième surface d'appui (630) opposée à la deuxième surface d'appui (620) et la deuxième barre omnibus (206, 208) présente une quatrième surface d'appui (236), la troisième surface d'appui (620) étant en contact avec la quatrième surface d'appui (236).

7. Système électronique (104) selon la revendication précédente dans lequel la cale (610) est distincte du support (210) et la cale (610) est en appui sur le support (210) lors de l'insertion de l'unité électronique (410) dans le boitier (502) dans le sens opposé au sens d'insertion de l'unité électronique (410) dans le boitier (502).

8. Système électronique (104) selon la revendication précédente dans lequel la cale (610) est montée par verrouillage de forme sur la deuxième barre omnibus (206, 208).

9. Système électronique (104) selon une des revendications précédentes dans lequel la première barre omnibus (506, 508) est une barre omnibus d'un module électronique de puissance (110) apte à alimenter les bobinages de phase d'une machine électrique tournante (130).

10. Système électronique (104) selon une des revendications précédentes dans lequel l'unité électronique (410) est un bloc de filtrage comprenant un condensateur (124) dont une borne est directement connectée à la deuxième barre omnibus (206, 208) notamment par soudage, brasage ou sertissage.

11. Système électronique (104) selon une des revendications précédentes dans lequel la distance entre la première surface de connexion (526) et la deuxième surface de connexion (226) est comprise entre 0 et 0,7mm, de préférence entre 0 et 0,5mm.

12. Système électronique (104) selon une des revendications précédentes la première extrémité de connexion (516) de la première barre omnibus (506, 508) est soudée, notamment par soudure Laser, à la deuxième extrémité de connexion (216) de la deuxième barre omnibus (206, 208).

13. Système électronique (104) selon l'une des revendications précédentes dans lequel l'unité électronique (410) comprend un couvercle (310) comprenant une partie métallique au droit d'un interstice formé entre la première surface de connexion (526) de la première barre omnibus (506, 508) et la deuxième surface de connexion (226) de la deuxième barre omnibus (206, 208) dans la direction d'insertion (S).

14. Ensemble électrique (100) comprenant :
a. un système électronique (104) selon l'une des revendications précédente,
b. une machine électrique tournante (130).

## Patentansprüche

1. Elektronisches System (104), welches umfasst:
a. ein Gehäuse (502), das eine erste Anlagefläche (552) aufweist,
b) eine erste Sammelschiene (506, 508), die am Gehäuse befestigt ist und ein erstes Verbindungsende (516) umfasst, das eine erste Verbindungsfläche (526) aufweist,
c. eine elektronische Einheit (410), die eine zweite Anlagefläche (620) umfasst, wobei die elektronische Einheit (410) dazu bestimmt ist, in das Gehäuse (502) entlang einer Einsetzrichtung (S) eingesetzt zu werden, und die elektronische Einheit (410) umfasst:
i. einen Träger (210),
ii. eine zweite Sammelschiene (206, 208), die am Träger (210) befestigt ist und ein zweites Verbindungsende (216) umfasst, das eine zweite Verbindungsfläche (226) aufweist,
wobei die zweite Anlagefläche (620) dazu bestimmt ist, beim Einsetzen der elektronischen Einheit (410) in das Gehäuse (502) auf der ersten Anlagefläche (552) zu gleiten, wobei eine von der ersten Anlagefläche (552) und der zweiten Anlagefläche (620) eine Rampe (562) umfasst, die in Bezug auf die Einsetzrichtung (S) geneigt ist, um die zweite Sammelschiene (206, 208) so zu verformen, dass beim Einsetzen der elektronischen Einheit (410) in das Gehäuse (502) die zweite Verbindungsfläche (226) an die erste Verbindungsfläche (526) angenähert wird.

2. Elektronisches System (104) nach Anspruch 1, wobei die Rampe in der zweiten Sammelschiene (206, 208) ausgebildet ist.

3. Elektronisches System (104) nach Anspruch 1, wobei die Rampe (562) in der ersten Anlagefläche (552) ausgebildet ist.

4. Elektronisches System (104) nach Anspruch 3, wobei ein Distanzstück (610) von der zweiten Sammelschiene (206, 208) getragen wird und zwischen dem Gehäuse (502) und der zweiten Sammelschiene (206, 208) angeordnet ist.

5. Elektronisches System (104) nach Anspruch 1, wobei die Rampe (562) in der zweiten Anlagefläche (620) ausgebildet ist, wobei die zweite Anlagefläche Bestandteil eines Distanzstücks (610) ist, das von der zweiten Sammelschiene (206, 208) getragen wird und zwischen dem Gehäuse (502) und der zweiten Sammelschiene (206, 208) angeordnet ist.

6. Elektronisches System (104) nach einem der Ansprüche 4 und 5, wobei das Distanzstück (610) eine dritte Anlagefläche (630) aufweist, die der zweiten Anlagefläche (620) gegenüberliegt, und die zweite Sammelschiene (206, 208) eine vierte Anlagefläche (236) aufweist, wobei sich die dritte Anlagefläche (630) in Kontakt mit der vierten Anlagefläche (236) befindet.

7. Elektronisches System (104) nach dem vorhergehenden Anspruch, wobei das Distanzstück (610) von dem Träger (210) verschieden ist und das Distanzstück (610) beim Einsetzen der elektronischen Einheit (410) in das Gehäuse (502) in der zur Einsetzrichtung der elektronischen Einheit (410) in das Gehäuse (502) entgegengesetzten Richtung am Träger (210) anliegt.

8. Elektronisches System (104) nach dem vorhergehenden Anspruch, wobei das Distanzstück (610) formschlüssig an der zweiten Sammelschiene (206, 208) angebracht ist.

9. Elektronisches System (104) nach einem der vorhergehenden Ansprüche, wobei die erste Sammelschiene (506, 508) eine Sammelschiene eines elektronischen Leistungsmoduls (110) ist, das geeignet ist, die Phasenwicklungen einer rotierenden elektrischen Maschine (130) mit Strom zu versorgen.

10. Elektronisches System (104) nach einem der vorhergehenden Ansprüche, wobei die elektronische Einheit (410) ein Filterblock ist, der einen Kondensator (124) umfasst, von dem eine Klemme direkt mit der zweiten Sammelschiene (206, 208) verbunden ist, insbesondere durch Schweißen, Löten oder Crimpen.

11. Elektronisches System (104) nach einem der vorhergehenden Ansprüche, wobei der Abstand zwischen der ersten Verbindungsfläche (526) und der zweiten Verbindungsfläche (226) zwischen 0 und 0,7 mm beträgt, vorzugsweise zwischen 0 und 0,5 mm.

12. Elektronisches System (104) nach einem der vorhergehenden Ansprüche, wobei das erste Verbindungsende (516) der ersten Sammelschiene (506, 508) an das zweite Verbindungsende (216) der zweiten Sammelschiene (206, 208) angeschweißt ist, insbesondere durch Laserschweißen.

13. Elektronisches System (104) nach einem der vorhergehenden Ansprüche, wobei die elektronische Einheit (410) eine Abdeckung (310) umfasst, die einen metallischen Teil genau gegenüber einem Zwischenraum umfasst, der zwischen der ersten Verbindungsfläche (526) der ersten Sammelschiene (506, 508) und der zweiten Verbindungsfläche (226) der zweiten Sammelschiene (206, 208) in der Einsetzrichtung (S) ausgebildet ist.

14. Elektrische Baugruppe (100), welche umfasst:
a. ein elektronisches System (104) nach einem der vorhergehenden Ansprüche,
b. eine rotierende elektrische Maschine (130).

## Claims

1. Electronic system (104) comprising:
a. a casing (502) comprising a first bearing surface (552),
b. a first busbar (506, 508) attached to the casing and comprising a first connection end (516) having a first connection surface (526),
c. an electronic unit (410) comprising a second bearing surface (620), the electronic unit (410) being intended to be inserted into the casing (502) in an insertion direction (S) and the electronic unit (410) comprising:
i. a support (210),
ii. a second busbar (206, 208) attached to the support (210) and comprising a second connection end (216) having a second connection surface (226),
the second bearing surface (620) being intended to slide on the first bearing surface (552) when the electronic unit (410) is inserted into the casing (502),
wherein one from among the first bearing surface (552) and the second bearing surface (620) comprises a ramp (562) that is inclined relative to the insertion direction (S) for deforming the second busbar (206, 208) so as to bring the second connection surface (226) closer to the first connection surface (526) when the electronic unit (410) is inserted into the casing (502).

2. Electronic system (104) according to Claim 1, wherein the ramp is formed in the second busbar (206, 208).

3. Electronic system (104) according to Claim 1, wherein the ramp (562) is formed in the first bearing surface (552) .

4. Electronic system (104) according to Claim 3, wherein a shim (610) is borne by the second busbar (206, 208) and interposed between the casing (502) and the second busbar (206, 208).

5. Electronic system (104) according to Claim 1, wherein the ramp is formed in the second bearing surface (620), the second bearing surface forming part of a shim (610) borne by the second busbar (206, 208) and interposed between the casing (502) and the second busbar (206, 208) .

6. Electronic system (104) according to one of Claims 4 and 5, wherein the shim (610) has a third bearing surface (630) opposite the second bearing surface (620) and the second busbar (206, 208) has a fourth bearing surface (236), the third bearing surface (620) being in contact with the fourth bearing surface (236).

7. Electronic system (104) according to the preceding claim, wherein the shim (610) is distinct from the support (210) and the shim (610) bears on the support (210) when the electronic unit (410) is inserted into the casing (502) in the opposite direction to the direction of insertion of the electronic unit (410) into the casing (502).

8. Electronic system (104) according to the preceding claim, wherein the shim (610) is mounted in a form-locking manner on the second busbar (206, 208).

9. Electronic system (104) according to one of the preceding claims, wherein the first busbar (506, 508) is a busbar of a power electronic module (110) able to supply the phase windings of a rotary electric machine (130) .

10. Electronic system (104) according to one of the preceding claims, wherein the electronic unit (410) is a filter block comprising a capacitor (124), one terminal of which is directly connected to the second busbar (206, 208), in particular by welding, brazing or crimping.

11. Electronic system (104) according to one of the preceding claims, wherein the distance between the first connection surface (526) and the second connection surface (226) is between 0 and 0.7 mm, preferably between 0 and 0.5 mm.

12. Electronic system (104) according to one of the preceding claims, the first connection end (516) of the first busbar (506, 508) is welded, in particular by laser welding, to the second connection end (216) of the second busbar (206, 208).

13. Electronic system (104) according to one of the preceding claims, wherein the electronic unit (410) comprises a cover (310) comprising a metal part in line with a gap formed between the first connection surface (526) of the first busbar (506, 508) and the second connection surface (226) of the second busbar (206, 208) in the insertion direction (S).

14. Electrical assembly (100) comprising:
a. an electronic system (104) according to one of the preceding claims,
b. a rotary electric machine (130).
